Europäisches Patentamt

European Patent Office

Office européen des brevets

(19)

(11) Numéro de publication : **0 526 589 B1**

(12) # FASCICULE DE BREVET EUROPEEN

(45) Date de publication du fascicule du brevet :
**22.06.94 Bulletin 94/25**

(51) Int. Cl.⁵ : **H03H 9/145, H03H 9/64**

(21) Numéro de dépôt : **91919033.0**

(22) Date de dépôt : **12.04.91**

(86) Numéro de dépôt international :
**PCT/FR91/00308**

(87) Numéro de publication internationale :
**WO 91/16763 31.10.91 Gazette 91/25**

(54) **FILTRE A ONDES DE SURFACE ET A FAIBLES PERTES.**

(30) Priorité : **24.04.90 FR 9005189**

(43) Date de publication de la demande :
**10.02.93 Bulletin 93/06**

(45) Mention de la délivrance du brevet :
**22.06.94 Bulletin 94/25**

(84) Etats contractants désignés :
**DE GB**

(56) Documents cités :
**EP-A- 0 158 402**
**IEEE Ultrasonics Symposium, volume 1 2%**
**octobre 1988, (Chicago Illinois, US) P. Dufilie**
**et al.: "A low loss high performance fillter**
**structure" page 127-130 voir page 127,**
**colonne de gauche, lignes 18-33; page 127,**
**colonne de droite, ligne 29 - page 129, colonne**
**de gauche, ligne 29: figures 1,3 (cité dans la**
**demande)**

(56) Documents cités :
**1982 Ultrasonics Symposium Proceedings,**
**volume 1, 27-29 octobre 1982, (San Diego) C.L.**
**West: "Saw convolver employing unidirec-**
**tional transducers for improved efficiency"**
**page 119-123 voir page 119, colonne de droite,**
**lignes 136; figure 1**

(73) Titulaire : **THOMSON-CSF**
**173, Boulevard Haussmann**
**F-75008 Paris (FR)**

(72) Inventeur : **DUFILIE, Pierre**
**190 Echo Drive**
**Vernon, CT 06066 (US)**
Inventeur : **HODE, Jean-Michel**
**3, rue Paul-Cézanne**
**F-06560 Valbonne (FR)**

(74) Mandataire : **Desperrier, Jean-Louis et al**
**THOMSON-CSF**
**SCPI**
**B.P. 329**
**50, rue Jean-Pierre Timbaud**
**F-92402 Courbevoie Cédex (FR)**

EP 0 526 589 B1

## Description

La présente invention se rapporte à un filtre hyperfréquences à ondes acoustiques de surface et à faibles pertes.

Le type de filtre à hautes performance et à faible pertes qui est concerné par l'invention est par exemple tel que décrit dans l'article de Messieurs DUFILIE, HODE, et DESBOIS : "A low loss high performance filter structure", IEEE 1988 Ultrasonic Symposium (Chicago), pages 1 à 4. Le filtre décrit dans cet article comporte :

- deux transducteurs d'entrée unidirectionnels placés symétriquement de part et d'autre d'un premier transducteur bidirectionnel de couplage et reliés acoustiquement à ce dernier ;
- un deuxième transducteur bidirectionnel de couplage, relié électriquement à ce premier transducteur bidirectionnel de couplage ;
- deux transducteurs de sortie unidirectionnels, placés symétriquement de part et d'autre de ce deuxième transducteur bidirectionnel de couplage et reliés acoustiquement à ce dernier ; et
- deux bornes d'entrée et de sortie reliées électriquement respectivement la première aux deux transducteurs d'entrée et l'autre aux deux transducteurs de sortie.

L'invention vise à améliorer les performances de ce genre de filtre à ondes de surface. Elle se rapporte à cet effet à un filtre à ondes de surface comportant, d'une manière très générale :

- . un ou plusieurs transducteurs d'entrée, reliés électriquement à la borne d'entrée du filtre, et reliés acoustiquement à au moins un premier transducteur de couplage, pondéré ou non ;
- . au moins un deuxième transducteur de couplage, pondéré ou non, relié électriquement à ce premier transducteur de couplage ; et relié acoustiquement à un ou plusieurs transducteurs de sortie, eux-mêmes reliés électriquement à la borne de sortie du filtre ;
- . un ou plusieurs transducteurs unidirectionnels à "coupleur en 0", ce filtre étant tel que le transducteur qui est entouré de ce coupleur en 0 est décalé par rapport à l'axe de ce coupleur qui est normal à la direction de propagation des ondes de surface, d'une distance qui est égale au huitième de la longueur d'onde de propagation des ondes de surface, augmentée d'un nombre entier de demi-longueurs d'onde ;
- . deux couples de transducteurs unidirectionnels à coupleur en 0, dont un premier couple associé à l'entrée du filtre et un deuxième couple associé à sa sortie,

ce filtre étant principalement caractérisé en ce que les diamètres intérieurs, pris dans le sens de propagation des ondes de surface, des deux coupleurs en 0 du premier et/ou du deuxième de ces coupleurs de transducteurs, diffèrent pour les deux coupleurs en 0 d'un même couple, d'une demi-longueur d'onde de propagation des ondes de surface, à un nombre entier M de longueurs d'onde près, ce nombre M pouvant être différent pour le premier et le deuxième couple.

Selon une autre particularité, il s'agit d'un filtre comportant, côté entrée, soit deux transducteurs d'entrée latéraux reliés acoustiquement à un transducteur de couplage central, soit un transducteur d'entrée central relié acoustiquement à deux transducteurs de couplage latéraux, et comportant côté sortie, une configuration de transducteurs semblable à celle du côté entrée, caractérisé en ce que, côté entrée et/ou côté sortie du filtre, les distances respectives entre l'axe de chaque transducteur d'entrée, ou de sortie, et celui du transducteur de couplage qui lui est associé différent, pour un même couple de distances relatif à l'entrée ou à la sortie du filtre, d'un nombre entier de longueurs d'onde, ce nombre entier pouvant être différent côté entrée du côté sortie.

Selon encore une autre particularité, il s'agit d'un filtre comportant, côté entrée, soit deux transducteurs d'entrée latéraux reliés acoustiquement à un transducteur de couplage central, soit un transducteur d'entrée central relié acoustiquement à deux transducteurs de couplage latéraux, et comportant, côté sortie, une configuration de transducteurs semblables à celle du côté entrée, caractérisé en ce que les distances respectives entre l'axe d'un transducteur d'entrée ou de sortie et celui du transducteur de couplage qui lui est associé, différent, d'un transducteur d'entrée à un transducteur de sortie, d'un quart de longueur d'onde, à un nombre entier de demi-longueurs d'ondes près, et aux différences de phase des coefficients de réflexion sur les transducteurs de couplage près.

Enfin, selon une dernière particularité, il s'agit d'un filtre utilisant des transducteurs de couplage pondérés, caractérisé en ce que les pondérations de ces transducteurs de couplage sont différentes et sont choisies pour obtenir, dans la bande passante du filtre, une réponse sensiblement identique pour ces transducteurs de couplage, et à contrario une réponse différente en dehors de la bande passante de ce filtre.

De toute façon, l'invention sera bien comprise, et ses avantages et autres caractéristiques ressortiront, lors de la description suivante d'un exemple non limitatif de réalisation, en référence au dessin schématique annexé dans lequel :

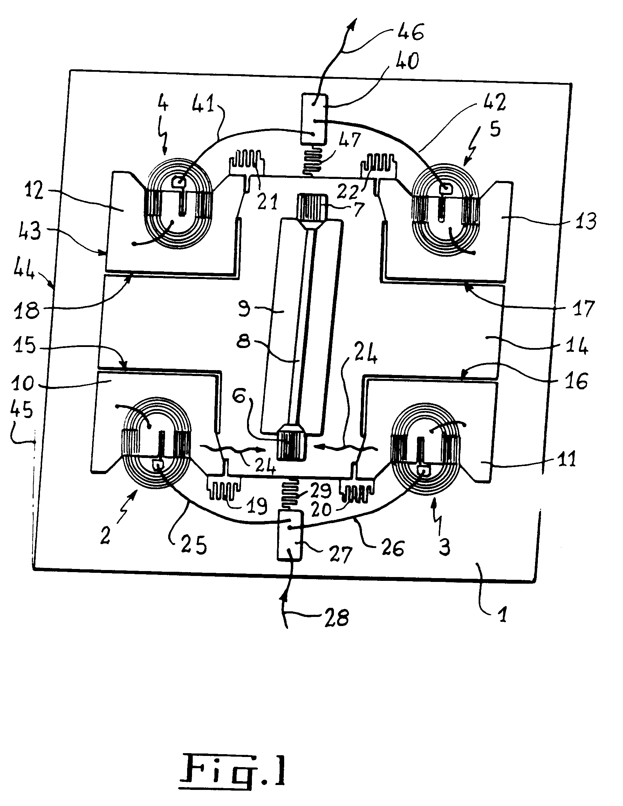

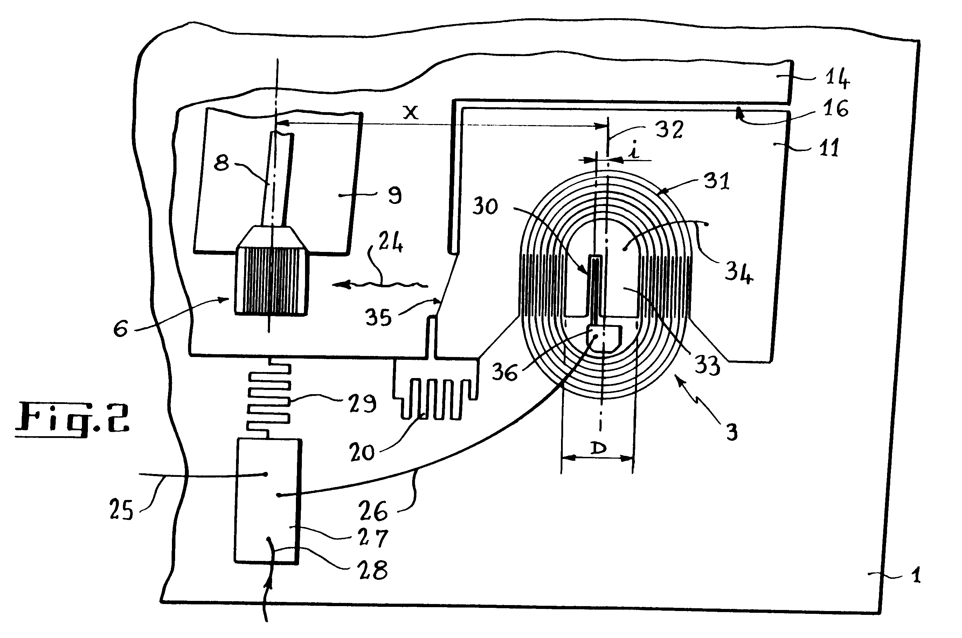

- . Figure 1 est une vue d'ensemble de ce filtre à ondes acoustique de surface ; et
- . Figure 2 est une vue agrandie d'une portion (quart-inférieur droit) de ce même filtre.

En se reportant tout d'abord à l'ensemble des figures 1 et 2, il s'agit d'une structure de filtre hyperfréquences à ondes acoustiques de surface et à faibles pertes. Ce filtre comporte, classiquement, sur un substrat isolant 1, une paire de transducteurs d'entrée unidirectionnels 2, 3 et une autre paire de transducteurs unidirectionnels 4, 5 de sortie, couplés acoustiquement par l'intermédiaire d'un transducteur bidirectionnel de couplage d'entrée 6 et d'un transducteur bidirectionnel de couplage de sortie 7.

Les deux transducteurs de couplage 6, 7 qui sont ici des transducteurs pondérés à grand nombre de doigts, sont reliés électriquement l'un à l'autre par une bande métallique 8 déposée sur une autre bande 9, isolante et plus large. Bien entendu, la bande métallisée 8 peut être remplacée par un fil soudé.

Les quatres transducteurs unidirectionnels d'entrée/sortie 2 à 5 ont des masses respectives 10 à 13 qui sont séparées de la masse 14 des transducteurs de couplage 6, 7 par des intervalles respectifs 15 à 18. Ces masses sont avantageusement reliées entre elles par des résistances électriques 19 à 22, de manière à supprimer les effets pyroélectriques néfastes.

A noter que les bords 43, 44 des plans de masse et du substrat 1 sont classiquement inclinés par rapport à la normale 45 à la direction 24 de propagation des ondes acoustiques de surface, ce qui évite d'être gêné par des réflexions sans avoir à utiliser d'absorbeur acoustique.

Les transducteurs d'entrée 2, 3 sont reliés électriquement, par des fils respectifs 25 et 26, à un pavé d'entrée métallisé 27 qui reçoit le fil d'entrée 28 du filtre et qui est protégé des décharges électrostatiques par une résistance 29. Il en est de même symétriquement pour les transducteurs de sortie 4, 5 (voir le pavé 40, les fils de connexion 41, 42, le fil de sortie 46, et la résistance 47).

Chacun des transducteurs unidirectionnels 2 à 5 est (voir en particulier le transducteur 3 en vue agrandie sur la figure 2), de manière très classique, un transducteur unidirectionnel dit "à coupleur en 0". Il est de ce fait composé d'un transducteur "central" 30, qui est dans cet exemple un transducteur à large bande dit "court", c'est à dire ayant un très petit nombre de doigts actifs, ce transducteur central étant entouré d'un coupleur "multistrip" 31 en forme de 0 et étant décalé par rapport à l'axe 32 de ce coupleur 31 qui est normal à la direction 24 précitée d'une distance i qui, dans les transducteurs unidirectionnels classiques de ce type est égale au huitième de la longueur d'onde λ de propagation des ondes acoustiques de surface : on verra, ci-après que, selon une des caractéristiques de la présente invention, cet écartement i est ici différent de la valeur λ/8.

Le connexion de masse du point froid 33 du transducteur 30 est réalisée par la liaison en pont 34 qui relie ce point froid 33 à la plaque de masse 11.

Le plan de masse 14 relatif aux transducteurs de couplage 6 et 7 agit comme un blindage entre les transducteurs d'entrée 2, 3 et de sortie 4, 5. Les séparations 15 à 18 précitées comportent, sur toute l'ouverture acoustique des deux transducteurs acoustiquement associés, tels que 6 et 3 par exemple (voir la figure 2), un fin intervalle 35 qui est incliné par rapport à la direction 24 de propagation des ondes acoustiques de surface.

les métallisations 36 et 33 correspondent respectivement aux bornes "signal" (point chaud) et "masse" (point froid) du transducteur 30.

Selon une première caractéristiques, particulière et conforme à l'invention, de ce filtre, le décalage i précité est à peuprès égal au huitième de la longueur d'onde λ de propagation des ondes acoustiques de surface, augmenté d'un nombre entier N de demi-longueurs d'onde, soit :

$$i = λ/8 + N λ/2$$

ce qui a pour effet d'obtenir, hors bande, des zéros dans la fonction de transfert du coupleur 31, et par suite d'améliorer la réjection lointaine (ou réjection hors-bande) du filtre.

Ces décalages i peuvent être différents selon qu'il s'agit des transducteurs unidirectionnels d'entrée 2, 3, ou des transducteurs unidirectionnels de sortie 4, 5.

Selon une deuxième particularité de ce filtre, les "diamètres" intérieurs D, pris dans le sens 24 de propagation des ondes de surface, relatifs aux deux coupleurs en 0 associés aux deux transducteurs d'entrée 2 et 3 (voir le coupleur 31 sur la figure 2) et/ou ceux relatifs, aux deux coupleurs en 0 associés aux deux transducteurs de sortie 4, 5, diffèrent pour un même couple (2, 3 ou 4, 5) d'une demi-longueur d'onde λ, à un nombre entier M de longueurs d'ondes près, l'un par rapport à l'autre, ce nombre M pouvant être différent pour les deux transducteurs d'entrée et pour les deux transducteurs de sortie. Par exemple, ces deux diamètres D diffèrent de $M_1 λ + λ/2$ pour les deux transducteurs d'entrée 2, 3 tandis qu'ils diffèrent de $M_2 λ + λ/2$ pour les deux transducteurs de sortie 4, 5, $M_1$ et $M_2$ pouvant être des entiers (0, 1 , 2,...) différents.

Ce décalage a pour effet de mettre en opposition de phase les ondes réfléchies à droite et à gauche du coupleur en 0, et donc de les supprimer. Il s'agit de réflexions d'origine essentiellement mécanique, qui sont dues au fait que la surface du substrat piézoélectrique 1 est chargée par des métallisations.

Selon une troisième particularité, relative là encore au couple de transducteurs d'entrée 2, 3 et/ou au couple de transducteurs de sortie 4, 5, les distances X (voir figure 2) entre les axes respectifs de chaque transducteur (3 par exemple) et celui du transducteur de couplage (6 dans cet exemple) qui lui est associé, diffèrent, pour un couple de transducteurs (d'entrée et/ou de sortie), d'un nombre entier K de longueurs d'onde, ce nombre entier K pouvant être différent pour le couple de transducteurs d'entrée (2, 3) et pour le couple de transducteurs de sortie. Cette particularité permet, par la création de creux de réjection hors-bande dans la fonction de transfert du filtre, d'améliorer sa réjection lointaine hors-bande.

Selon une quatrième particularité, dont le but est de remédier aux perturbations dues aux réflexions de double-transit, les distances X précitées diffèrent, d'un transducteur d'entrée 2 ou 3 à un transducteur de sortie 4 ou 5, d'un quart de longueur d'onde $\lambda$, à un nombre entier P de demi-longueurs d'ondes près et aux différences de phase des coefficients de réflexion en attaque symétrique $Rc_1$, $Rc_2$ sur les deux transducteurs de couplage 6, 7 près. Par exemple, la distance $X_2$ relative au transducteur de sortie 4 est liée à celle $X_1$ relative au transducteur d'entrée 2 par la relation suivante :

$$X2 - X_1 = \lambda/4 + \frac{\varphi}{4\pi}\lambda + P\,\lambda/2$$

où $\varphi$ est défini par $Rc_2/Rc_1 = \left|\dfrac{Rc_2}{Rc_1}\right|\,e^{-j\varphi}$

Une cinquième caractéristique concerne les pondérations des transducteurs de couplage 6,7. Il est connu, dans ce type de filtre, que les transducteurs de couplage doivent avoir des admittances presque identiques dans la bande passante du filtre et qu'il faut pondérer ces transducteurs pour abaisser les lobes secondaires.

Selon cette cinquième caractéristique, les pondérations des transducteurs de couplage 6, 7 sont différentes, et elles sont choisies pour obtenir, dans la bande passante du filtre, une réponse sensiblement identique pour ces transducteurs de couplage 6, 7, et à contrario une réponse différente en dehors de la bande passante du filtre. Cette particularité entraîne une diminution de l'amplitude des lobes secondaires, et donc améliore la réjection hors-bande du filtre.

L'adaptation électrique des transducteurs de couplage 6, 7 peut indifféremment être une adaptation "parallèle" ou "série", bien connues dans la technique, ou encore une adaptation en "impédance conjuguée" telle que décrite dans la demande de brevet français de la Demanderesse N° 8813536, déposée le 14 octobre 1988.

Les transducteurs proprement dits d'entrée-sortie (tels que le transducteur 30, figure 2), sont, dans cet exemple, des transducteurs dits "courts", ayant entre 3 et 8 doigts actifs par exemple. Ils pourraient tout aussi bien être des transducteurs pondérés de la même manière que les transducteurs de couplage 6, 7 pour avoir une faible réactance capacitive à la fréquence centrale. Dans ce dernier cas, le filtre ne nécessite pas de circuit d'adaptation électrique lorsque l'impédance ramenée des deux transducteurs d'entrée ou de sortie est proche de l'impédance de la source de la charge.

Comme il va de soi, l'invention n'est pas limitée à l'exemple de réalisation qui vient d'être décrit. Elle s'applique par exemple aussi, en ce qui concerne les caractéristiques ne faisant pas intervenir les coupleurs en 0, à des filtres de structure semblable mais utilisant d'autres transducteurs unidirectionnels que des transducteurs à coupleur en 0. Elle s'applique également à toutes sortes de variantes imaginables de cette structure de filtre. Une telle variante pourrait consister, à titre d'exemple nullement limitatif, en un filtre du même genre que celui de la figure 1, mais comportant un seul transducteur d'entrée axial et bidirectionnel réémettant de part et d'autre vers deux transducteurs de couplage d'entrée unidirectionnels, eux-mêmes reliés électriquement à deux transducteurs de couplage de sortie, eux-aussi unidirectionnels, et réémettant vers un unique transducteur de sortie, lui-aussi axial et bidirectionnel: dans une telle configuration, qui est inverse de celle de la figure 1 tout en assurant la même fonction, il y a en tout quatre transducteurs de couplage et seulement deux transducteurs d'entrée/sortie.

**Revendications**

1. Filtre à ondes de surface du type comportant :
   . un ou plusieurs transducteurs d'entrée (2,3) relié(s) acoustiquement à au moins un premier transducteur de couplage (6), et
   . au moins un deuxième transducteur de couplage (7) relié électriquement à ce premier transducteur de couplage (6), et relié acoustiquement à un ou plusieurs transducteurs de sortie (4, 5) ; plusieurs de ces transducteurs étant du type unidirectionnel (2 à 4) à "coupleur en 0" (31), et le transducteur (30) qui est entouré de ce coupleur en 0 (31) étant décalé par rapport à l'axe (32) de ce coupleur (31) qui est normal à la direction (24) de propagation des ondes de surface, d'une distance (i) qui est égale au huitième de la longueur d'onde de propagation des ondes de surface, augmentée d'un nombre entier (N) de demi-longueurs d'onde ($\lambda/2$) ; ce filtre comportant deux couples de transducteurs unidirectionnels (2 à 5) à coupleur en 0 (31), dont un premier couple (2, 3) associé à l'entrée du filtre et un deuxième couple (4 ,5) associé à sa sortie,
   caractérisé en ce que les diamètres intérieurs (D), pris dans le sens (24) de propagation des ondes de surface, des deux coupleurs en 0 du premier (2, 3) et/ou du deuxième (4, 5) de ces coupleurs de transducteurs, diffèrent, pour les deux coupleurs en 0 d'un même couple, d'une demi-longueur d'onde de propagation ($\lambda$) des ondes de surface, à un nombre entier M de longueurs d'onde (λ) près, ce nombre M pouvant être différent pour le premier (2, 3) et le deuxième couple (4, 5).

2. Filtre à ondes de surface selon la revendication 1, du type comportant, côté entrée, soit deux transducteurs d'entrée latéraux (2, 3) reliés acoustiquement à un transducteur de couplage central (6), soit un transducteur d'entrée central relié acoustiquement à deux transducteurs de couplage latéraux, et comportant, côté sortie, une configuration de transducteurs (4, 5, 7) semblable à celle (2, 3, 6) du côté entrée, caractérisé en ce que, côté entrée et/ou côté sortie du filtre, les distances respectives (X) entre l'axe 32 de chaque transducteur d'enteée (2 ou 3), ou de sortie (4 ou 5), et celui du transducteur de couplage (6 ou 7) qui lui est associé différent, pour un même couple de distances (X) relatif à l'entrée ou à la sortie du filtre, d'un nombre entier (K) de longueurs d'onde (λ), ce nombre entier (K) pouvant être différent côté entrée du côté sortie.

3. Filtre à ondes de surface selon l'une des revendications 1 à 2, du type comportant, côté entrée, soit deux transducteurs d'entrée latéraux (2, 3) reliés acoustiquement à un transducteur de couplage central (6), soit un transducteur d'entrée central relié acoustiquement à deux transducteurs de couplage latéraux, et comportant, côté sortie, une configuration de transducteurs (4, 5, 7) semblable à celle (2, 3, 6) du côté entrée, caractérisé en ce que les distances respectives (X) entre l'axe (32) d'un transducteur d'entrée ou de sortie et celui du transducteur de couplage (6 ou 7) qui lui est associé, différent, d'un transducteur d'entrée (2 ou 3) à un transducteur de sortie (4 ou 5), d'un quart de longueur d'onde (λ), à un nombre entier (P) de demi-longueurs d'ondes près, et aux différences de phases ( $\frac{\varphi}{4\pi}\lambda$ ) des coefficients de réflexion en attaque symétrique (Rc1, Rc2) sur les transducteurs de couplage (6, 7) près.

4. Filtre à ondes de surface selon l'une des revendications 1 à 3, du type utilisant des transducteurs de couplage pondérés (6, 7), caractérisé en ce que les pondérations de ces transducteurs de couplage (6, 7) sont différentes et sont choisies pour obtenir, dans la bande passante du filtre, une réponse sensiblement identique pour ces transducteurs de couplage (6, 7), et à contrario une réponse différente en dehors de la bande passante de ce filtre.

**Patentansprüche**

1. Oberflächenwellenfilter, das aufweist:
   - mindestens einen Eingangstransduktor (2, 3), der akustisch mit mindestens einem ersten Kopplungstransduktor (6) verbunden ist, und
   - mindestens einen zweiten Kopplungstransduktor (7), der elektrisch mit dem ersten Kopplungstransduktor (6) und akustisch mit mindestens einem Ausgangstransduktor (4, 5) verbunden ist, wobei mehrere dieser Transduktoren vom Typ des in einer Richtung wirkenden Transduktors (2 bis 4) als Ringkoppler (31) ausgebildet sind, während der Transduktor (30), der von diesem Ringkoppler (31) umgeben ist, bezüglich der Achse (32) dieses Kopplers (31), die senkrecht zur Fortpflanzungsrichtung (24) der Oberflächenwelle verläuft, um einen Abstand (i) verschoben ist, der gleich 1/8 der Wellenlänge der Oberflächenwelle plus ein ganzzahliges Vielfaches (N) der halben Wellenlänge (λ/2) verschoben ist, wobei dieses Filter zwei Paare von in einer Richtung wirkenden Transduktoren (2 bis 5) mit Ringkopplern (31) aufweist, von denen ein erstes Paar (2, 3) dem Eingang des Filters und ein zweites Paar (4, 5) dem Ausgang des Filters zugeordnet ist, dadurch gekennzeichnet, daß der Innendurchmesser (D) der beiden Ringkoppler des ersten (2, 3) und/oder des zweiten Transduktorpaars (4, 5) in Fortpflanzungsrichtung (24) der Oberflächenwellen sich für die beiden Ringkoppler eines Paars um die Hälfte der Fortpflanzungswellenlänge (λ) der Oberflächenwelle plus ein ganzzahliges Vielfaches M der Wellenlänge (λ) unterscheidet, wobei die Zahl M für das erste Paar (2, 3) sich von der für das zweite Paar (4, 5) unterscheiden kann.

2. Oberflächenwellenfilter nach Anspruch 1, das auf der Eingangsseite entweder zwei seitliche Eingangstransduktoren (2, 3), die akustisch an einen zentralen Kopplungstransduktor (6) angeschlossen sind, oder einen zentralen Eingangstransduktor, der akustisch an zwei seitliche Kopplungstransduktoren angeschlossen ist, und auf der Ausgangsseite eine ähnliche Transduktorkonfiguration (4, 5, 7) wie auf der Eingangsseite (2, 3, 6) besitzt, dadurch gekennzeichnet, daß auf der Eingangsseite und/oder auf der Ausgangsseite des Filters die Abstände (X) zwischen der Achse (32) jedes Eingangstransduktors (2 oder 3) oder Ausgangstransduktors (4 oder 5) und der des zugeordneten Kopplungstransduktors (6 oder 7) sich für ein gleiches Paar von Abständen (X) bezüglich des Eingangs oder Ausgangs des Filters um ein ganzzahliges Vielfaches (K) der Wellenlänge ($\lambda$) unterscheidet, wobei dieses Vielfache (K) auf der Eingangsseite ein anderes sein kann als auf der Ausgangsseite.

3. Oberflächenwellenfilter nach einem der Ansprüche 1 bis 2, das auf der Eingangsseite entweder zwei seitliche Eingangstransduktoren (2, 3), die akustisch an einen zentralen Kopplungstransduktor (6) angeschlossen sind, oder einen zentralen Eingangstransduktor aufweist, der akustisch an zwei seitliche Kopplungstransduktoren angeschlossen ist, wobei auf der Ausgangsseite eine ähnliche Transduktorkonfiguration (4, 5, 7) wie auf der Eingangsseite (2, 3, 6) vorliegt, dadurch gekennzeichnet, daß die Abstände (X) zwischen der Achse (32) eines Eingangstransduktors oder Ausgangstransduktors und dem zugeordneten Kopplungstransduktor (6 oder 7) sich von einem Eingangstransduktor (2 oder 3) zu einem Ausgangstransduktor (4 oder 5) um ein Viertel der Wellenlänge ($\lambda$) plus ein ganzzahliges Vielfaches (P) der halben Wellenlänge plus die Phasendifferenzen ($\varphi.\lambda/4\pi$) der Reflexionskoeffizienten (Rc1, Rc2) bei symmetrischer Ansteuerung der Kopplungstransduktoren (6, 7) unterscheiden.

4. Oberflächenwellenfilter nach einem der Ansprüche 1 bis 3, das gewichtete Kopplungstransduktoren (6, 7) verwendet, dadurch gekennzeichnet, daß die Gewichtungen dieser Kopplungstransduktoren (6, 7) sich voneinander unterscheiden und so gewählt sind, daß im Durchlaßband des Filters eine im wesentlichen identische Kennlinie für diese Kopplungstransduktoren (6, 7) erreicht wird, dagegen eine unterschiedliche Kennlinie außerhalb des Durchlaßbands des Filters.

**Claims**

1. Surface wave filter of the type including:
   . one or more input transducers (2,3) acoustically linked to at least one first coupling transducer (6), and
   . at least one second coupling transducer (7) electrically linked to this first coupling transducer (6), and acoustically linked to one or more output transducers (4, 5); several of these transducers being of the "O-coupler" (31) unidirectional type (2 to 4), and the transducer (30) which is surrounded by this O-coupler (31) being offset with respect to the axis (32) of this coupler (31) which is normal to the direction (24) of propagation of the surface waves, by a distance (i) which is equal to an eighth of the propagation wavelength of the surface waves, increased by a whole number (N) of half-wavelengths ($\lambda/2$); this filter including two pairs of O-coupler (31) unidirectional transducers (2 to 5), a first pair (2, 3) of which is associated with the input of the filter and a second pair (4, 5) of which is associated with its output,
characterized in that the inside diameters (D) taken in the direction (24) of propagation of the surface waves, of the two O-couplers of the first (2, 3) and/or of the second (4, 5) of these transducer couplers differ, for the two O-couplers of the same pair, by half of a wavelength of propagation ($\lambda$) of the surface waves, to within a whole number M of wavelengths ($\lambda$), this number M possibly being different for the first (2, 3) and the second pair (4, 5).

2. Surface wave filter according to Claim 1, of the type including, on the input side, either two lateral input transducers (2, 3) acoustically linked to a central coupling transducer (6), or a central input transducer acoustically linked to two lateral coupling transducers, and including, on the output side, a configuration of transducers (4, 5, 7) which is similar to that (2, 3, 6) on the input side, characterized in that, on the input side and/or on the output side of the filter, the respective distances (X) between the axis 32 of each input (2 or 3), or output (4 or 5), transducer, and that of the coupling transducer (6 or 7) which is associated with it differ, for the same pair of distances (X) relating to the input or to the output of the filter, by a whole number (K) of wavelengths ($\lambda$), this whole number (K) possibly being different between the input side and the output side.

3. Surface wave filter according to either of Claims 1 or 2, of the type including, on the input side, either two lateral input transducers (2, 3) acoustically linked to a central coupling transducer (6), or a central input transducer acoustically linked to two lateral coupling transducers, and including, on the output side, a configuration of transducers (4, 5, 7) which is similar to that (2, 3, 6) of the input side, characterized in that the respective distances (X) between the axis (32) of an input or output transducer and that of the coupling transducer (6 or 7) which is associated with it, differ, from one input transducer (2 or 3) to one output transducer (4 or 5), by a quarter wavelength ($\lambda$), to within a whole number (P) of half-wavelengths, and to within the phase differences ($\Phi/4\pi \times \lambda$) of the reflection coefficients, in symmetric drive (Rc1, Rc2) on the coupling transducers (6, 7).

4. Surface wave filter according to one of Claims 1 to 3, of the type using weighted coupling transducers (6, 7), characterized in that the weightings of these coupling transducers (6, 7) are different and are chosen in order to obtain, in the pass band of the filter, a substantially identical response for these coupling transducers (6, 7), and, in contrast, a different response outside the pass band of this filter.

**Fig.1**

Fig.2